# EUROPÄISCHE PATENTSCHRIFT

(11) **EP 3 449 512 B1**
(45) Veröffentlichungstag und Bekanntmachung des Hinweises auf die Patenterteilung: **22.01.2020**
(21) Anmeldenummer: 17716901.8
(22) Anmeldetag: 12.04.2017
(51) Int. Cl.: H01L 31/068

(54) **VERFAHREN ZUR HERSTELLUNG RÜCKSEITENKONTAKTIERTER SOLARZELLEN AUS KRISTALLINEM SILIZIUM**
METHOD FOR PRODUCING REAR SURFACE CONTACT SOLAR CELLS FROM CRYSTALLINE SILICON
PROCÉDÉ DE FABRICATION DE CELLULES PHOTOVOLTAÏQUES À CONTACTS ÉLECTRIQUES SUR LA FACE ARRIÈRE, RÉALISÉES EN SILICIUM CRISTALLIN

(30) Priorität: 27.04.2016 DE 102016107802
(43) Veröffentlichungstag der Anmeldung: 06.03.2019
(73) Patentinhaber: EnBW Energie Baden-Württemberg AG, 76131 Karlsruhe (DE)
(72) Erfinder: DAHLINGER, Morris, 70197 Stuttgart (DE); CARSTENS, Kai, 70190 Stuttgart (DE); WERNER, Juergen H., 70197 Stuttgart (DE); KOEHLER, Juergen, 71332 Waiblingen (DE); EISELE, Sebastian, 72293 Glatten (DE); ROEDER, Tobias, 80686 München (DE); HOFFMANN, Erik, 70176 Stuttgart (DE)
(74) Vertreter: DREISS Patentanwälte PartG mbB
(86) Internationale Anmeldenummer: PCT/EP2017/058746
(87) Internationale Veröffentlichungsnummer: WO 2017/186488

(56) Entgegenhaltungen:
- DE-A1-102013 112 638
- US-A1- 2010 294 349
- DAHLINGER MORRIS ET AL: "Laser-Doped Back-Contact Solar Cells", IEEE JOURNAL OF PHOTOVOLTAICS, I E E E, US, Bd. 5, Nr. 3, 1. Mai 2015 (2015-05-01), Seiten 812-818, XP011578924, ISSN: 2156-3381, DOI: 10.1109/JPHOTOV.2015.2411058 [gefunden am 2015-04-17]

## Beschreibung

Die Erfindung betrifft ein Verfahren zur Herstellung rückseitenkontaktierter Solarzellen aus kristallinem Silizium.

Bekannte Fertigungsverfahren verwenden Ofendiffusion zur Erzeugung von n-Typ-dotierten und p-Typ-dotierten Bereichen und zur Kontaktierung aufgedampfter Metalle. Für die bei rückseitenkontaktierten Solarzellen notwendige strukturierte Herstellung der dotierten Bereiche als auch für die Metallisierung sind Maskierschritte notwendig. Da der Silizium-Wafer im Diffusionsofen überall dieselbe Temperatur besitzt, findet die Diffusion gleichmäßig auf der gesamten Oberfläche statt. Eine Erzeugung unterschiedlich dotierter Streifen- oder Punktstrukturen der n- und p-Typ Bereiche auf der Rückseite der Solarzelle erfordert deshalb für jede der Diffusionen entweder eine Maskierung, welche ein Eindiffundieren der Dotier-Atome lokal verhindert, oder aber einen lokalen Ätzschritt nach der Diffusion, um den nicht zu diffundierenden Bereich zu entfernen. In beiden Fällen ist sowohl die Aufbringung einer diffusionshemmenden Maskierungsschicht oder einer ätzresistenten Schutzschicht als auch deren hochauflösende Strukturierung erforderlich. Da sowohl eine Bor-Diffusion als auch eine Phosphor-Diffusion lokal erfolgen muss, sind diese Schritte vor der Durchführung der Ofendiffusion notwendig und müssen zusätzlich mit hoher Präzision aufeinander ausgerichtet werden. Auch eine Öffnung einer Rückseitenpassivierungsschicht zur Kontaktierung der Solarzelle erfordert eine hohe Präzision, so dass ein Lithographieschritt erforderlich ist. Weiterhin erfordert die Aufbringung der Metallkontakte zusätzlich mindestens einen Lithographieschritt. Sofern zwei unterschiedliche Metalle verwendet werden, sind zwei Lithographieschritte notwendig.

Aus den oben dargestellten Gründen ist die Herstellung rückseitenkontaktierter Solarzellen mittels Maskierungstechnik über Lithographie nicht wirtschaftlich.

Gemäß der WO 2007/081510 A2 wird eine rückseitenkontaktierte Solarzelle aus kristallinem Silizium hergestellt, indem Precursor-Schichten zur nachfolgenden Ofendiffusion lokal mittels Siebdrucken oder Tintenstrahldrucken aufgedruckt werden.

Eine derartige Herstellung führt zu ungenauer Abstimmung der dotierten Bereiche und somit zu einem nicht optimalen Wirkungsgrad.

Aus der DE 10 2004 036 220 A1 ist es grundsätzlich bekannt, mittels Laserdotierung dotierte Bereiche an Festkörpern mit einer hohen Defektfreiheit zu erzeugen. Hierbei wird zunächst ein Medium, welches einen Dotierstoff enthält, in Kontakt mit einer Oberfläche des Festkörpers gebracht. Anschließend wird durch Bestrahlung mit Laserimpulsen ein Bereich des Festkörpers unterhalb der mit dem Medium kontaktierten Oberfläche kurzzeitig aufgeschmolzen, so dass der Dotierstoff in den aufgeschmolzenen Bereich eindiffundiert und während des Abkühlens der aufgeschmolzene Bereich defektfrei rekristallisiert.

Grundsätzlich lassen sich mit einem derartigen Verfahren Maskierungsschritte und Lithographieschritte zum Dotieren durch Ofendiffusion vermeiden. Es verbleibt das Problem einer einfachen und kostengünstigen Kontaktierung an der Rückseite der Solarzelle.

Aus der WO 2015/071217 A1 ist es bekannt, zur Herstellung der dotierten Bereiche ein Laser-Dotierverfahren zu verwenden. Mittels Laserablation werden Kontaktflächen an der Rückseite der Solarzelle freigelegt, die anschließend mittels Siebdruck kontaktiert werden (vgl. hierzu auch M. Dahlinger, et al., "Laser-Doped Back-Contact Solar Cells", IEEE Journal of Photovoltaics, Vol. 5, No. 3, Mai 2015, S. 812-818, sowie M. Dahlinger, et al., "Laser Doped Screen-printed Back Contact Solar Cells Exceeding 21% Efficiency", Energy Procedia, Vol. 55, September 2014, S. 410 - 415).

Beim Siebdruck handelt es sich zwar um ein kostengünstiges und gut erprobtes Verfahren, allerdings lässt sich mittels Siebdruck keine hohe Präzision erzielen, wodurch der Wirkungsgrad begrenzt ist. Ferner ist die Rekombination von Ladungsträgern bei Siebdruck höher als etwa an etwa mittels PVD (physikalische Gasphasenabscheidung) abgeschiedenen Kontakten.

Aus der WO 2006/042698 A1 ist es bekannt, zur Kontaktierung bei einer rückseitenkontaktierten Solarzelle zunächst eine Metallschicht auf der Rückseite zu erzeugen, dann eine Ätzbarriereschicht abzuscheiden, diese dann selektiv mittels eines Lasers zu entfernen und schließlich durch einen Ätzschritt die elektrische Trennung zwischen den verschiedenen Polaritäten zu erreichen.

Grundsätzlich wird allerdings ein weiter erhöhter Wirkungsgrad angestrebt.

Gemäß der WO 2015/047952 A1 wird eine Metallfolie zur Kontaktierung appliziert. Durch einen Laser wird die Folie selektiv verschweißt und zwischen den verschiedenen Polaritäten getrennt.

Ein derartiges Verfahren ist sehr zeit- und kostenintensiv.

Gemäß P. Verlinden et al., "High Efficiency large Area Back Contact Concentrator Solar Cells with a Multilevel Interconnection", International Journal of Solar Energy, 1988, Vol. 6, S. 347-366 ist es bekannt, bei rückseitenkontaktierten Solarzellen unter Verwendung eines Anodisierungsverfahrens die Kontaktierung herzustellen. Das Verfahren ist wegen diverser Schritte einschließlich verschiedener Lithographieschritte sehr aufwändig.

Aus der US 2016/0020343 A1 ist es schließlich bekannt, mittels eines Laser-Transferprozesses Dotiermittel oder elektrisch leitfähiges Material zu übertragen, etwa um eine Fingerstruktur zur Kontaktierung zu erzeugen.

Eine Übertragung durch Laser-Transfer ist ein ziemlich aufwändiges Verfahren. Außerdem wird ein weiter erhöhter Wirkungsgrad angestrebt. Ferner ist ein Lasertransfer meistens auf Saatschichten, also dünne Schichten von wenigen 10 Nanometer Dicke begrenzt. Diese reichen als Metallisierung für einen Stromtransport nicht aus und müssen in der Regel nachfolgend verdickt werden, was einen weiteren Verfahrensschritt erfordert.

Vor diesem Hintergrund liegt der Erfindung die Aufgabe zugrunde, ein Verfahren zur Herstellung rückseitenkontaktierter Solarzellen aus kristallinem Silizium zu schaffen, das eine möglichst einfache und kostengünstige Herstellung mit hoher Qualität und möglichst hohem Wirkungsgrad erlaubt.

Diese Aufgabe wird durch ein Verfahren zur Herstellung rückseitenkontaktierter Solarzellen aus kristallinem mit den folgenden Schritten gelöst:
(a) Dotieren zur Erzeugung eines n-Typ- oder p-Typ-dotierten Bereiches, vorzugsweise mittels Laserdotierung;
(b) Freilegung von Kontaktflächen an der Rückseite der Solarzelle, vorzugsweise mittels Laserablation;
(c) Applizieren einer Metallschicht auf eine Rückseite der Solarzelle; und
(d) Strukturieren der Metallschicht mittels Laserablation zur Erzeugung von metallischen Kontakten, wobei der Pitch höchstens 800 Mikrometer beträgt.

Die Aufgabe der Erfindung wird auf diese Weise vollkommen gelöst.

Da die Herstellung von Kontakten an der Rückseite der Solarzelle durch einen Laserablationsschritt gemäß (d) erfolgt, ist es auf Grund der hohen Präzision möglich, einen kleinen Pitch zu erhalten, der höchstens 800 Mikrometer beträgt, vorzugsweise höchstens 500 Mikrometer, weiter bevorzugt höchstens 100 Mikrometer, besonders bevorzugt höchstens 60 Mikrometer beträgt. Es kann sich beispielsweise um einen Pitch von etwa 50 Mikrometer handeln.

Es wurde erfindungsgemäß erkannt, dass der Wirkungsgrad ansteigt, je kleiner der Pitch ist.

Um einen möglichst geringen Pitch zu erlauben, sollten auch die übrigen Schritte bei der Solarzellenherstellung, wie etwa die Herstellung der dotierten Bereiche und die Freilegung von Kontaktflächen, möglichst unter Vermeidung von Lithographie- und Maskierungsschritten und unter Vermeidung von Drucktechniken erfolgen, um insgesamt eine möglichst hohe Präzision zu gewährleisten. Bevorzugt wird hierzu jeweils die Lasertechnik eingesetzt.

In Abhängigkeit von der Präzision bei der Justierung des verwendeten Lasers ist der Pitch nach unten begrenzt. Eine Untergrenze stellt ein Pitch von etwa 5 Mikrometer dar.

Es versteht sich, dass der Begriff "Solarzelle" in seinem weitesten Sinne zu verstehen ist. Darunter fallen auch Sonderformen, wie etwa Photozellen.

In dem erfindungsgemäßen Verfahren wird im Schritt (c) eine Aluminiumschicht appliziert, dann eine gegen eine Eloxierung resistente Schicht appliziert, die im nachfolgenden Schritt (d) mittels Laser selektiv ablatiert wird und anschließend in den ablatierten Bereichen vollständig anodisiert wird.

Auf diese Weise wird anstatt einer vollständigen Entfernung des zwischen benachbarten Polaritäten bestehenden Aluminiums eine vollständige Umwandlung in Aluminiumoxid erreicht, was gleichfalls Kurzschlüsse sicher ausschließt.

Ein gewisser Vorteil ergibt sich durch die verbleibende ebene Oberfläche.

In zusätzlicher Weiterbildung der Erfindung werden die metallischen Kontakte durch Busbars verschaltet werden, die aus Streifen aus Metallfolie bestehen, die unter Zwischenlage mindestens einer dielektrischen Schicht mittels Laserschweißen durch die dielektrische Schicht hindurch kontaktiert werden.

Gemäß einer ersten Ausgestaltung der Erfindung werden Streifen aus eloxierter Aluminiumfolie zur Erzeugung der Busbars verwendet. Der Laserschweißprozess erfolgt durch die isolierende Schicht hindurch zu je einer Polarität.

Es kann natürlich auch eine andere dielektrische Schicht bzw. ein Schichtstapel auf den Folienstreifen oder auf der Rückseite des Wafers zur Isolierung verwendet werden.

Zur Erzeugung eines p-Typ-Emitters und/oder zur Erzeugung eines n-Typ-Back Surface Fields (BSF) auf der Rückseite der Solarzelle wird vorzugsweise ein Laserdotierschritt verwendet.

Hierzu wird vorzugsweise zunächst eine Precursor-Schicht, die einen Dotierstoff, insbesondere Bor, Aluminium oder Gallium enthält, auf der Rückseite der Solarzelle abgeschieden und ein p-Typ-Emitter durch lokale Bestrahlung mittels eines gepulsten Lasers erzeugt.

Alternativ kann der p-Typ-Emitter lokal durch Ionen-Implantation mit einem Dotierstoff, insbesondere Bor, Aluminium oder Gallium, erzeugt werden.

Auch auf diese Weise lässt sich der Emitter ohne Maskierungs- oder Lithographieschritte mit hoher Präzision erzeugen.

Gemäß einer weiteren Ausgestaltung der Erfindung wird bei der Emitter-Dotierung mittels Laserbestrahlung durch Strahlformung oder durch Einsatz eines weiteren unabhängig fokussierten Laserstrahls lokal unter den Emitter-Kontaktflächen eine höhere Dotierung erzeugt. Bei der Strahlformung ist entscheidend, dass die Pulsenergiedichte im Gebiet der Kontakte lokal erhöht ist, um dort eine höhere Dotierung zu erhalten. Eine entsprechende Strahlformung kann z. B. mit Hilfe eines diffraktiven optischen Elements erfolgen.

Auf diese Weise wird eine besonders verlustarme Kontaktierung in einfacher Weise ermöglicht.

Zur Laserdotierung wird vorzugsweise ein gepulster Laser verwendet, vorzugsweise mit einer Pulsdauer von 30 Nanosekunden bis 500 Nanosekunden, weiter vorzugsweise mit einer Wellenlänge von 500 bis 600 Nanometer, weiter vorzugsweise mit einer Pulswiederholrate von 1 kHz bis 2 MHz, weiter vorzugsweise mit einer Pulsenergiedichte von 1 J/cm² bis 5 J/cm².

Durch die Verwendung eines derartigen Lasers ergibt sich eine optimale Abstimmung auf die Dotieraufgabe. Die Siliziumoberfläche und die Precursor-Schicht können auf diese Weise lokal so weit erhitzt werden, dass der Dotiervorgang lokal bis zur gewünschten Tiefe in kürzester Zeit durchgeführt werden kann, wobei gleichzeitig eine Überdotierung vermieden werden kann. Durch eine lokale Variation der Pulsenergiedichte kann die Dotierung sowohl in den Kontaktgebieten, als auch in den nicht kontaktierten Gebieten des Emitters gleichzeitig optimal angepasst werden.

Vorzugsweise wird der Laserstrahl mittels einer Optik auf einen rechteckigen Bereich X • Y abgebildet, und Laser und Substrat werden inkremental relativ zueinander um eine Schrittlänge L bewegt, um vorbestimmte Flächen zu dotieren.

Auf diese Weise kann eine präzise Dotierung in rechteckförmigen oder linienförmigen Bereichen erzeugt werden.

Hierbei beträgt die Breite X vorzugsweise 0,02 bis 2 Millimeter, während die Länge Y vorzugsweise zwischen 5 Mikrometer und 500 Mikrometer liegt.

Vorzugsweise beträgt die Schrittlänge L, um die das Substrat und der Laser inkremental zueinander bewegt werden, zwischen 0,1 • Y und Y. Durch wiederholtes Bestrahlen und Verschieben des Silizium-Wafers oder durch Verschieben des auf die Oberfläche abgebildeten Laserstrahls in Y-Richtung um die Schrittlänge L wird die gesamte gewünschte Fläche eines Streifens oder Punktes dotiert.

In vorteilhafter Weiterbildung der Erfindung wird zur Erzeugung eines n-Typ Back Surface Fields (BSF) auf der Rückseite der Solarzelle zunächst eine Phosphor-Silikatglasschicht (PSG) als Precursor auf dem Substrat abgeschieden, die anschließend mittels eines Lasers zur Erzeugung einer n-Typ-Dotierung bestrahlt wird. Die Abscheidung der PSG Schicht erfolgt gleichzeitig mit einer Vorderseitendotierung (Front Surface Field, FSF) des Wafers in einem Hochtemperatur-Diffusionsofen. Die Erzeugung eines FSF ermöglicht eine verbesserte Passivierung der Solarzellen-Vorderseite.

Vorzugsweise wird die Phosphor-Silikatglasschicht nach der Laserdotierung durch Ätzen entfernt und anschließend die phosphordotierte Schicht zumindest auf der Rückseite des Substrates teilweise zurückgeätzt.

Das Zurückätzen erfolgt, abhängig von der Tiefe und Phosphorkonzentration auf beiden Seiten des Silizium-Wafers oder nur auf der Rückseite. Ziel des Rückätzschrittes ist es, den in den Bor-Emitter-Bereichen vorhandenen Phosphor zu reduzieren. Die Phosphor-Oberflächenkonzentration im Emitter-Bereich kann durch den Rückätzschritt so eingestellt werden, dass diese nach einer nachfolgenden thermischen Oxidation mindestens fünffach kleiner ist als die Bor-Oberflächenkonzentration.

Eine Reduktion der Phosphorkonzentration auf der Vorderseite ist erforderlich, falls diese zu hoch phosphordotiert ist. Angestrebt ist hierbei eine Phosphor-Oberflächenkonzentration von etwa 1 • 10¹⁸ cm⁻³ bis 1 • 10²⁰ cm⁻³ nach einem nachfolgenden thermischen Oxidationsschritt für eine optimale Vorderseitenpassivierung durch das so erzeugte FSF. Zusätzlich wird durch die Rückätzung eine chemische Reinigung des Silizium-Wafers erreicht.

Nach der Laserdotierung der BSF-Schicht oder nach dem teilweisen Rückätzschritt wird eine thermische Oxidation im Bereich von 700 °C bis 1100 °C, vorzugsweise 800 °C bis 1050 °C, durchgeführt.

Bei diesem sog. Drive-in-Schritt wächst Siliziumdioxid als Oberflächenpassivierung auf. Ferner diffundieren aufgrund der hohen Temperaturen die Dotier-Atome weiter in den Silizium-Wafer hinein. Dadurch sinkt die Oberflächenkonzentration der Dotierung sowohl im Solarzellenemitter als auch im BSF und FSF .

In weiter bevorzugter Ausgestaltung der Erfindung wird auf der Vorderseite eine Anti-Reflexionsschicht abgeschieden, vorzugsweise eine Siliziumnitridschicht mittels PECVD abgeschieden.

Auf der Rückseite der Solarzelle wird vorzugsweise eine Stapelschicht aus siliziumarmem und siliziumreichem Siliziumoxid oder Siliziumnitrid vorzugsweise mittels PECVD abgeschieden.

Die siliziumarme Schicht hat hierbei vorzugsweise einen niedrigen Brechungsindex (n < 1,7) und eine Dicke zwischen 70 Nanometer und 300 Nanometer, während die nachfolgende siliziumreiche Schicht vorzugsweise eine Schicht mit hohem Brechungsindex (n > 2,7) und einer Dicke zwischen 10 Nanometer und 100 Nanometer ist. Beide Schichten können nacheinander im selben Prozessschritt in derselben Anlage abgeschieden werden. Sie erhöhen u. a. das "Light-Trapping" und passivieren die Rückseite. Ferner dient die hochbrechende Schicht als Ablations-Maskierschritt in den nachfolgenden Prozessschritten.

Nach dem Auftragen der Stapelschicht wird vorzugsweise mittels eines UV-Lasers eine Ablation zur Freilegung der zu kontaktierenden Bereiche durchgeführt, wobei vorzugsweise nur die zuletzt abgeschiedene siliziumreiche Schicht in den zu kontaktierenden Bereichen ablatiert wird, da nur diese die UV-Strahlung absorbiert. Die siliziumarme Schicht ist für die UV-Strahlung transparent und kann deshalb von dieser nicht absorbiert werden, wodurch ihre Ablation verhindert wird.

Die verbleibende Schicht bis zur Siliziumgrenzfläche kann dann für eine nachfolgende Kontaktierung weggeätzt werden.

Auf diese Weise erfolgt eine lokale Öffnung der Kontaktflächen ohne eine Laserschädigung an der Silizium-Oberfläche.

Auf der Vorderseite der Solarzelle wird vorzugsweise vor der Dotierung des Emitters eine Vorderseitentextur erzeugt. Dies kann durch nasschemisches Polieren und Texturätzen des Substrates an der Vorderseite erfolgen.

Das nasschemische Polieren kann hierbei als erster Schritt, ggf. auch einseitig, durchgeführt werden, woran sich ein einseitiges nasschemisches Texturätzen anschließt. Die Reihenfolge kann auch vertauscht werden, indem zunächst mit einer nasschemischen Texturätzung zur Erzeugung der Vorderseitentextur der Solarzelle begonnen wird, gefolgt von einer nasschemischen einseitigen Politur der Rückseite der Solarzelle und dem Abscheiden einer Bor-haltigen Precursor-Schicht auf der Rückseite der Solarzelle.

Eine rückseitenkontaktierte Solarzelle aus kristallinem Silizium, die nach dem vorstehend beschriebenen Verfahren hergestellt ist, weist einen Wafer mit einer Anti-Reflexionsschicht auf der Vorderseite, mit einem Emitter und einem Basisbereich (Back Surface Field) auf der Rückseite, sowie durch Laserablation hergestellte Kontakte auf der Rückseite, wobei der Pitch höchstens 800 Mikrometer beträgt. Vorzugsweise ist der Pitch deutlich geringer, etwa im Bereich von 100 Mikrometer oder geringer, wie z.B. etwa 50 Mikrometer.

Hierdurch ergibt sich ein hoher Wirkungsgrad. Außerdem wird die Abhängigkeit vom BSF-Anteil *f*_{BSF} reduziert.

Es versteht sich, dass die vorstehend genannten und die nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

Weitere Merkmale und Vorteile der Erfindung ergeben sich aus der nachfolgenden Beschreibung eines bevorzugten Ausführungsbeispiels unter Bezugnahme auf die Zeichnung. Es zeigen:
- Fig. 1: einen vereinfachten Querschnitt durch eine erfindungsgemäße Solarzelle;
- Fig. 2: eine schematische Darstellung der Aufsicht einer Einheitszelle der Rückseite der Solarzelle gemäß Fig. 1;
- Fig. 3a-f: den Wirkungsgrad einer Solarzelle in Abhängigkeit vom BSF-Anteil *f*_{BSF} und vom Pitch p der Solarzelle für verschiedene Waferqualitäten und

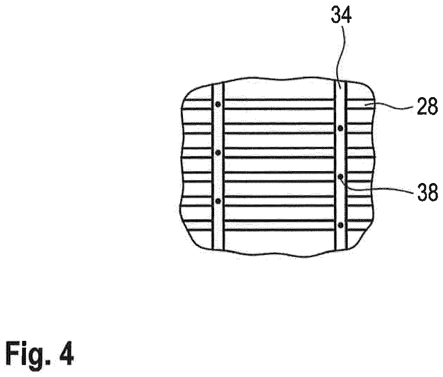

- Fig. 4: eine schematische Darstellung der Verbindung von Kontakten mittels Folienstreifen über Schweißpunkte.

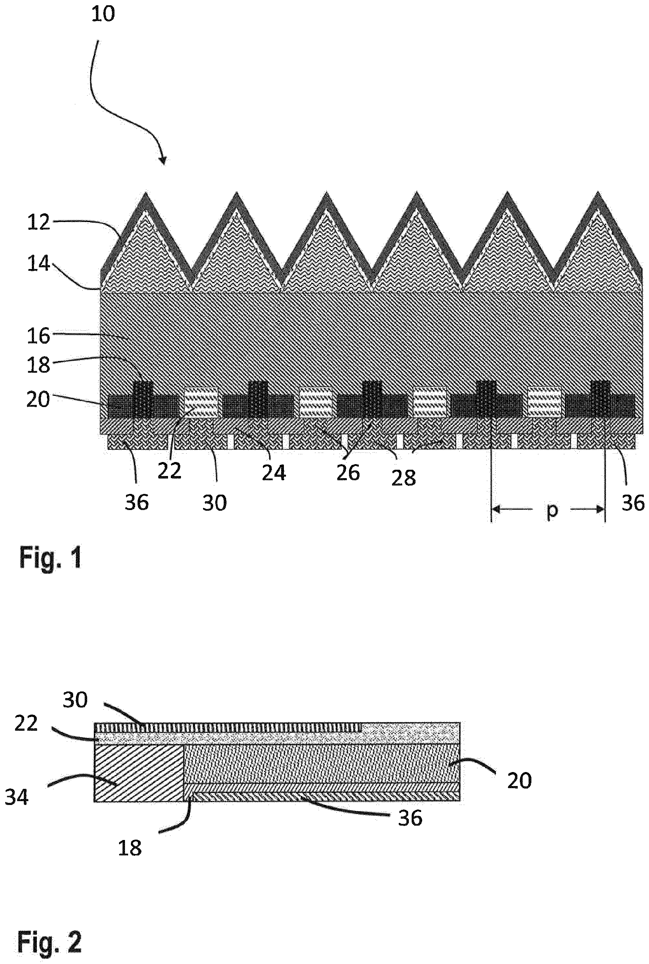

In Fig. 1 ist der Querschnitt einer erfindungsgemäßen Solarzelle schematisch dargestellt und insgesamt mit der Ziffer 10 bezeichnet.

Die Solarzelle 10 weist einen n-Typ-Silizium-Wafer 16 auf. An der Vorderseite ist dieser mit einer Passivier- und Anti-Reflexionsschicht 12 auf einer pyramidenartigen Textur versehen. Darunter befindet sich eine Vorderseiten-Phosphordiffusionsschicht, das Front Surface Field (FSF) 14.

An der Rückseite weist die Solarzelle 10 laserdotierte Bor-Emitterbereiche 20 auf, an denen jeweils selektiv stärker dotierte Emitter 18 ausgebildet sind, auf denen Kontakte 28 aufgebracht sind.

Auf der Rückseite der Solarzelle 10 befinden sich ferner mittels Phosphor laserdotierte Basisbereiche 22. Die Rückseite ist durch eine Passivierungsschicht 24 gegenüber den Kontakten 28 isoliert, durch die die Kontaktierung zu den selektiv dotierten Emittern 18 und den hochdotierten Basisbereichen 22 hergestellt ist.

Fig. 2 zeigt eine schematische Darstellung der Aufsicht einer Einheitszelle der Rückseite der Solarzelle 10 gemäß Fig. 1. An der Ober- und Unterseite der Zeichnung wird die Einheitszelle gespiegelt fortgesetzt. Dabei ist links und rechts der Solarzellenrand. 30 zeigt den Basiskontaktbereich. 22 bezeichnet den Basisbereich, der durch die BSF-Dotierung (Back Surface Field) entstanden ist. 34 bezeichnet die Dotierung für die Stromsammelschiene (Bus Bar). 20 bezeichnet die Emitter-Dotierung. 18 bezeichnet den selektiv höher dotierten Emitter. 36 bezeichnet schließlich den Emitter-Kontaktbereich.

Der sog. "Pitch" bezeichnet den Abstand zwischen zwei benachbarten Emittern 18 (der Pitch ist also gewissermaßen die "Periode" der Solarzelle). In Fig. 1 ist der Pitch mit p bezeichnet.

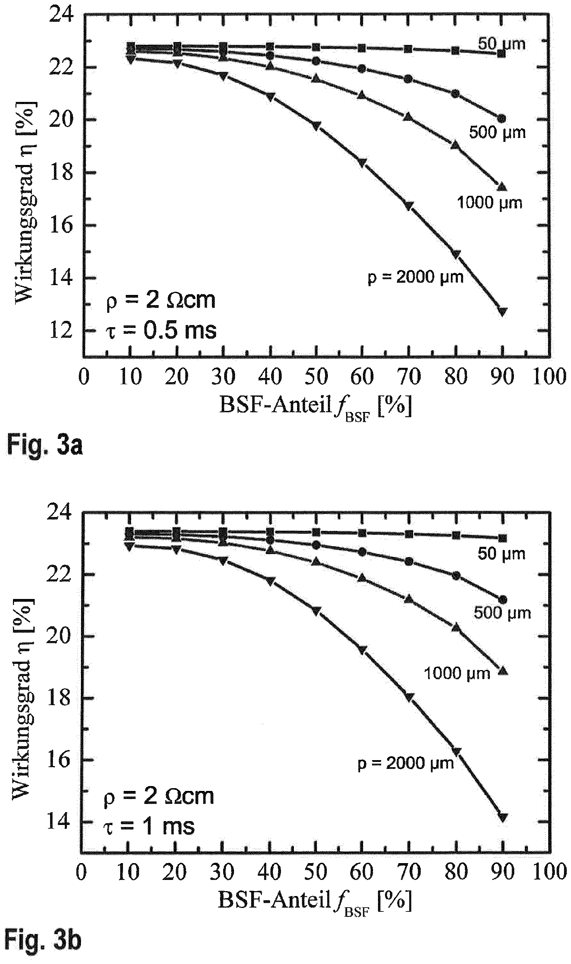

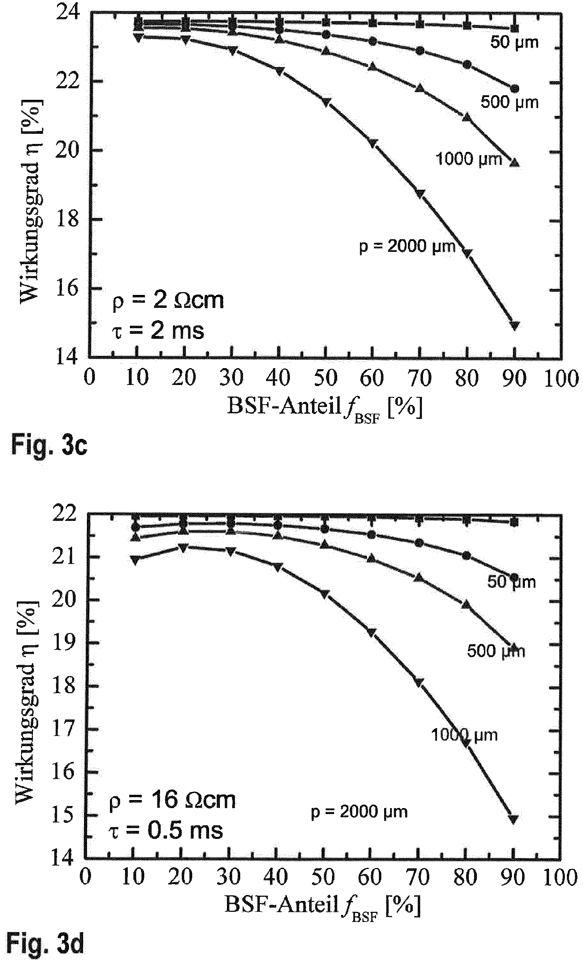

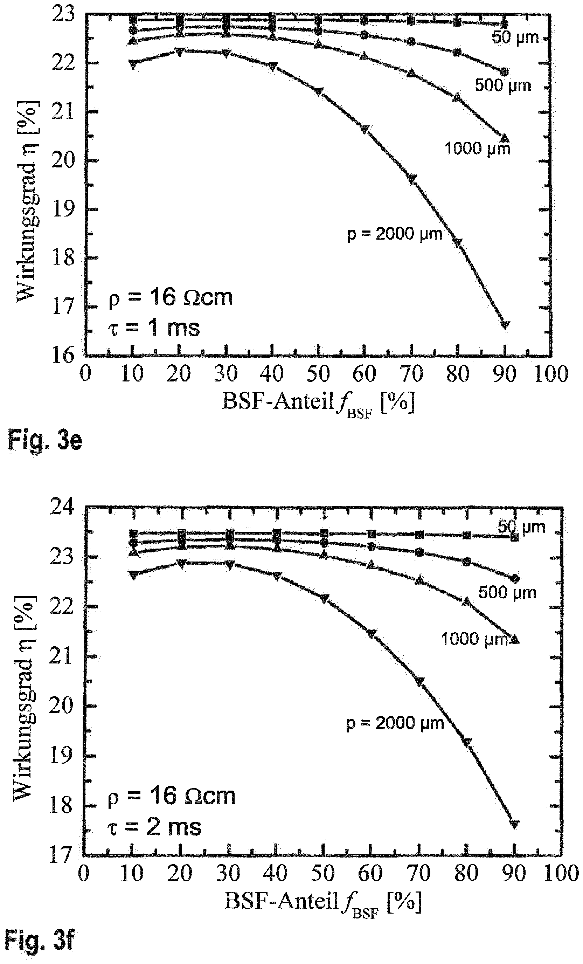

Fig. 3a-f zeigen die Abhängigkeit des relativen Wirkungsgrades einer Solarzelle in Abhängigkeit vom Pitch p und vom BSF-Anteil *f*_{BSF} (Flächenanteil des ohmschen Kontaktes (Basisbereich 22, BSF-Dotierung) zur Gesamtfläche (Basisbereich 22 plus Emitter 18)), und zwar für verschiedene Wafer. Dabei bedeutet p den spezifischen Widerstand des Wafers und τ die Volumenlebensdauer der Minoritätsladungsträger.

Es zeigt sich, dass unabhängig vom spezifischen Widerstand des Wafers und von der Volumenlebensdauer der relative Wirkungsgrad η umso größer ist, je kleiner der Pitch p ist. Außerdem wird die Abhängigkeit vom BSF-Anteil *f*_{BSF} umso geringer, je kleiner der Pitch p ist. Die bei größerem Pitch p ausgeprägten Maxima in Abhängigkeit vom BSF-Anteil *f*_{BSF} werden mit kleinerem Pitch p geglättet. Bei einem Pitch p von 50 Mikrometer besteht praktisch keine Abhängigkeit mehr vom BSF-Anteil *f*_{BSF}.

Diese Abhängigkeit vom Pitch p wird erfindungsgemäß ausgenutzt, um einen möglichst großen Wirkungsgrad zu erzielen.

Mit Hilfe der Lasertechnik gelingt es erfindungsgemäß, eine Solarzelle 10 mit einem Pitch < 800 Mikrometer, vorzugsweise < 100 Mikrometer, weiter bevorzugt < 60 Mikrometer, auf technisch relativ einfache Weise herzustellen. In der Regel ist der Pitch größer als 5 Mikrometer.

Die Herstellung einer derartigen Solarzelle 10 wird nachfolgend im Detail beschrieben.

Das erfindungsgemäße Verfahren kommt vollständig ohne Maskierschritte aus. Stattdessen werden Laserdotierschritte und ein Laserablationsschritt zur Öffnung der Rückseiten-Passivierungsschicht verwendet. Die Laserdotierung zur Erzeugung des Emitters kann optional auch durch einen lokalen Ionen-Implantationsschritt ersetzt werden. Ein weiterer Laserablationsschritt wird zur bei der Herstellung der Kontakte 28 für Emitter 18 und Basisbereiche 22 verwendet.

Zur Herstellung der Solarzelle 10 wird ein bereits grunddotierter n-Typ-Silizium-Wafer verwendet.

Auf der Vorderseite der Solarzelle 10 erfolgt zunächst eine nasschemische alkalische Texturierung zur Erzeugung einer pyramidenartig texturierten Oberfläche. Anschließend wird die Rückseite der Solarzelle 10 nasschemisch einseitig poliert (alkalisch oder sauer). Daran schließt sich die Abscheidung einer bor-, aluminium- oder galliumhaltigen Precursor-Schicht auf der Rückseite der Solarzelle 10 an. Die Reihenfolge dieser Schritte kann auch vertauscht werden: Es kann zunächst eine nasschemische Politur (ggf. auch einseitig) erfolgen, gefolgt von einer einseitigen nasschemischen Texturierung auf der Vorderseite der Solarzelle 10.

Die Precursor-Schicht auf der Rückseite der Solarzelle 10 kann z.B. mit Hilfe einer Sputteranlage, oder einer plasmachemischen Abscheideanlage z.B. APCVD, oder mit Hilfe eines Spin-Coating Verfahrens oder einer Sprühbeschichtungsanlge appliziert werden.

Anschließend wird ein p-Typ-Emitter auf der Rückseite der Solarzelle 10 mit Hilfe eines Laser-Dotierprozesses erzeugt. Hierbei schmilzt ein Laserpuls die Oberfläche des Silizium-Wafers auf. Aufgrund der hohen Diffusionskonstanten in flüssigem Silizium diffundieren die in der Precursor-Schicht vorhandenen Dotier-Atome während der Flüssigphase innerhalb von ca. 100 Nanosekunden bis zu einer Tiefe von ca. 1000 Nanometer in die Oberfläche des Silizium-Wafers und bilden so den p-Typ-Emitter.

Hierbei wird der Laserstrahl mit Hilfe einer Optik so auf die Silizium-Oberfläche abgebildet, dass ein einzelner Laserpuls einen scharf begrenzten rechteckigen Bereich mit einer Fläche der Größe X • Y aufschmilzt. Vorzugsweise ist 0,02 Millimeter < X < 2 Millimeter und 5 Mikrometer < Y < 500 Mikrometer. Hierbei definiert die Größe X die Breite der Emitter-Streifen oder-Punkte. Durch wiederholtes Bestrahlen und Verschieben des Silizium-Wafers oder durch Verschieben des auf die Oberfläche abgebildeten Laserstrahls in Y-Richtung um die Schrittlänge L wird die gesamte Fläche eines Emitter-Streifens oder-Punktes dotiert. Vorzugsweise ist hierbei 0,1 • Y < L < Y.

Zusätzlich wird bei der Emitter-Dotierung eine lokal erhöhte Bor-Dotierung unterhalb des Emitter-Bus-Bar-Bereiches erzeugt. Dies erfolgt entweder durch Strahlformung bei der Laserbestrahlung oder durch Verwendung eines weiteren, unabhängig fokussierten Laserstrahls. Bei der Strahlformung ist entscheidend, dass die Pulsenergiedichte im Gebiet der Kontakte lokal erhöht ist, um dort eine höhere Dotierung zu erhalten. Eine entsprechende Strahlformung kann z. B. mit Hilfe eines diffraktiven optischen Elements erfolgen.

Durch die lokal erhöhte Bor-Dotierung unterhalb des Emitter-Bus-Bar-Bereiches (auch selektiver Emitter genannt) wird ein verringerter Gesamtserienwiderstand und damit ein besserer Füllfaktor der Solarzelle erzielt. Durch die lokal erhöhte Bor-Dotierung unterhalb des Emitter-Kontaktes wird ferner die Rekombination von Ladungsträgern an der Metall-Halbleitergrenzfläche vermindert. Dadurch erhöht sich die Leerlaufspannung und somit der Wirkungsgrad der Solarzelle 10. Ferner wird der Kontaktwiderstand reduziert, wodurch der Gesamtserienwiderstand sinkt und der Füllfaktor steigt.

Beide lokale Dotierungen lassen sich ohne zusätzlichen Prozessschritt während des Emitter-Laserdotierens erzeugen. Durch eine Variation der Laserpulsenergiedichte werden das Dotierprofil und damit der Schichtwiderstand eingestellt.

Nach der Laser-Dotierung des Emitters 18 wird die verbliebene Precursor-Schicht nasschemisch entfernt. Die dazu verwendete chemische Lösung hängt von der verwendeten Precursor-Schicht ab.

Anschließend wird der Silizium-Wafer 16 durch eine Salzsäure-WasserstoffperoxidLösung und danach in einem Flusssäurebad gereinigt.

Alternativ zur oben beschriebenen Laserdotierung unter Verwendung einer zuvor abgeschriebenen Precursor-Schicht kann der mit Bor dotierte Emitter 18 der Solarzelle 10 auch mit Hilfe eines lokalen Ionen-Implantationsschrittes erzeugt werden. Eine defektfreie Rekristallisation des durch die Ionen-Implantation amorphisierten Siliziums sowie die Aktivierung der Dotier-Atome wird durch die noch später beschriebene thermische Oxidation erreicht, die sich auch im Falle eines Laserdotierungsschrittes anschließt.

Auf der Rückseite des Silizium-Wafers wird ferner ein sog. Back Surface Field (BSF) in Form eines hochdotierten n-Typ-Bereiches durch Laserdotierung unter Verwendung einer phosphorreichen Precursor-Schicht erzeugt.

Hierzu wird zunächst in einem Standard-Röhrenhochtemperaturofen eine phosphorreiche Phosphor-Silikatglasschicht sowohl auf der Vorderseite als auch auf der Rückseite des Silizium-Wafers abgeschieden. Hierbei dienen POCl₃ und O₂ als Prozessgase. Die Abscheidung erfolgt bei Temperaturen zwischen 700 °C und 850 °C. Dabei diffundiert ferner ein Teil des Phosphors wenige zig Nanometer bis 500 Nanometer in den Silizium-Wafer ein. Die Diffusion wird hierbei so optimiert, dass eine möglichst in die Tiefe flache und geringe Dotierung stattfindet, aber dennoch ein phosphorreiches Phosphorsilikatglas entsteht, bzw. eine phosphorreiche Grenzfläche vorliegt.

Die phosphorreiche Grenzfläche bzw. die Phosphor-Silikatglasschicht dient als Dotierquelle für einen nachfolgenden Laserdotierungsprozess.

Wie zuvor bei der Emitter-Dotierung beschrieben, schmilzt ein Laserimpuls hierbei die Oberfläche des Silizium-Wafers auf. Aufgrund der hohen Diffusionskonstante im flüssigen Silizium diffundieren die in der Phosphor-Silikatglasschicht vorhandenen Phosphor-Atome während der Flüssigphase innerhalb von ca. 100 Nanosekunden bis zu einer Tiefe von ca. 1000 Nanometer in die Oberfläche des Silizium-Wafers und bilden den BSF-Bereich 32, einen hochdotierten n-Typ-Bereich. Wie zuvor beschrieben, wird hierbei der Laserstrahl mit Hilfe einer Optik so auf die Silizium-Oberfläche abgebildet, dass ein einzelner Laserpuls einen scharf begrenzten rechteckigen Bereich mit einer Fläche der Größe X • Y aufschmilzt. Wiederum wird hierbei durch eine Relativbewegung zwischen Silizium-Wafer und Laserstrahl in Y-Richtung um die Schrittlänge L nach und nach die gesamte Fläche eines BSF-Streifens oder-Punktes dotiert. Im Übrigen werden hierbei die gleichen geometrischen Verhältnisse verwendet wie oben bereits im Zusammenhang mit der Emitter-Dotierung beschrieben.

Die Phosphorsilikatglasschicht wird nach der lokalen BSF-Laserdotierung mittels Flusssäurelösung (1 % bis 50 %) entfernt.

Anschließend wird die phosphordotierte Schicht zumindest auf der Rückseite des Substrates teilweise zurückgeätzt. Hierzu wird eine nasschemische Lösung aus Flusssäure, Salpetersäure, Essigsäure und deionisiertem Wasser verwendet, um etwa 10 Nanometer bis 300 Nanometer der phosphordotierten Schicht in der Tiefe zurückzuätzen. Dieser Ätzschritt erfolgt abhängig von der Tiefe und Phosphorkonzentration auf beiden Seiten des Silizium-Wafers oder nur auf der Rückseite. Ziel des Rückätzschrittes ist es, den in den Bor-Emitter-Bereichen vorhandenen Phosphor zu reduzieren.

Die Phosphor-Oberflächenkonzentration im Emitter-Bereich sollte nach der thermischen Oxidation, die nachfolgend beschrieben wird, mindestens fünffach kleiner sein als die Bor-Oberflächenkonzentration. Die Reduktion der Phosphorkonzentration auf der Vorderseite ist erforderlich, falls diese zu hoch phosphordotiert ist. Ziel ist es hierbei, eine Phosphor-Oberflächenkonzentration von 1 • 10¹⁸ cm⁻³ bis 1 • 10²⁰ cm⁻³ nach der folgenden Hochtemperaturoxidation zu erhalten. Zusätzlich dient der Rückätzschritt der chemischen Reinigung des Silizium-Wafers.

Anschließend wird zunächst eine nasschemische Reinigung durch eine Salzsäure-Wasserstoffperoxid-Lösung mit einem anschließenden Flusssäurebad durchgeführt.

Daran schließt sich eine thermische Oxidation als sog. Drive-in-Schritt an. Hierbei wächst eine Siliziumdioxid-Schicht als Oberflächenpassivierung auf. Alternativ kann auch eine Siliziumnitrid-Schicht, eine Siliziumoxinitrid-Schicht oder ein Siliziumkarbid-Schichtstapel verwendet werden. Beim Drive-in diffundieren aufgrund der hohen Temperaturen (etwa 800 °C bis 1050 °C) die Dotier-Atome weiter in den Silizium-Wafer hinein. Dadurch sinkt die Oberflächenkonzentration der Dotierung sowohl im Back Surface Field (BSF) (Basisbereich) und Front Surface Field (FSF), als auch im Emitter. Das entstehende Siliziumdioxid wächst bis zu einer Schichtdicke von 5 Nanometer bis 105 Nanometer auf, wobei in Kombination mit einer weiteren Anti-Reflexionsbeschichtung Schichtdicken im Bereich von 5 Nanometer bis 20 Nanometer angestrebt werden.

Um die effektive Reflexion der Solarstrahlung an der Oberfläche der Solarzelle 10 zu reduzieren, wird eine Siliziumnitridschicht auf der Vorderseite der Solarzelle 10 mittels plasmaunterstützter Gasphasenabscheidung (PECVD) abgeschieden. Der Brechungsindex sollte hierbei zwischen 1,9 und 2,3 liegen.

Auf der Rückseite der Solarzelle 10 wird vollflächig eine 1 bis 50 µm dicke Schicht aus Aluminium z.B. durch Verdampfen oder Kathodenzerstäubung aufgebracht. Diese Schicht dient zur späteren Erzeugung der Kontakte 28 auf den Basisbereichen 22 und den Emittern 18.

Auf die Aluminiumschicht wird eine metallische, halbleitende oder dielektrische Deckschicht durch etwa durch Verdampfen, APCVD, PECVD, CVD oder Kathodenzerstäuben aufgebracht. Diese Schicht soll ätzresistent oder nur geringfügig ätzbar sein gegenüber einem nachfolgend verwendeten Ätzmittel (etwa Phosphorsäure, Salzsäure, Natriumhydroxid oder Kaliumhydroxid). Sie kann z.B. aus Nickel, Zink, aus amorphem Silizium bzw. SiOx, aus Siliziumnitrid oder Siliziumkarbid bestehen.

Nunmehr erfolgt eine lokale Laserablation der auf die Aluminiumschicht aufgebrachten Deckschicht.

In einem nachfolgenden Ätzschritt wird mittels eines Ätzmittels (etwa Phosphorsäure, Salzsäure, Natriumhydroxid oder Kaliumhydroxid) das Aluminium in den mittels Laser freigelegten Bereichen entfernt, so dass sich voneinander isolierte Kontakte 28 auf den Basisbereichen 22 und den Emittern 18 ergeben.

Anstatt eine Isolation zwischen den alternierenden Kontaktbereichen durch Abtragung mittels Ätzen zu erzeugen, kann gemäß einer Verfahrensvariante eine Isolierung durch selektives Eloxieren einer Aluminiumschicht erzeugt werden.

Hierzu wird nach der Applizierung der Aluminiumschicht eine gegen eine Eloxierung resistente Schicht beispielsweise SiOₓ, SiNₓ, SiCₓ, Si, Ni, Cu, aufgetragen. Diese wird in eine im nachfolgenden Schritt mittels Laserablation selektiv abgetragen. Anschließend werden die ablatierten Bereiche in einem Eloxierbad (beispielsweise H₂SO₄ oder Oxalsäure) vollständig eloxiert (in Fig. 1 wären bei dieser Variante die zwischen benachbarten Kontakten 28 bestehenden Schlitze vollständig mit Aluminiumoxid aufgefüllt).

In jedem Falle wird durch die Verwendung der Lasertechnik ein sehr kleiner Pitch p ermöglicht, der in der Größenordnung von 100 µm oder sogar im Bereich von etwa 50 µm liegen kann. Wie aus den Fig. 3a-f ersichtlich, wird hierdurch der Wirkungsgrad η deutlich verbessert.

Bei den zuvor beschriebenen Laser-Dotierprozessen wird ein gepulstes Lasersystem verwendet (vgl. WO 2015/071217 A1 und DE 10 2004 036 220 A1, die hier vollständig durch Bezugnahme eingeschlossen werden). Für die Erzeugung eines optimierten Tiefenprofils der Dotierstoffe sind folgende Laserparameter bevorzugt:
- Pulsdauer zwischen 30 Nanosekunden und 500 Nanosekunden,
- Wellenlänge zwischen 500 Nanometer und 600 Nanometer,
- Pulswiederholrate zwischen 1 kHz und 2 MHz,
- Pulsenergiedichte zwischen 1 J/cm² und 5 J/cm².

Optional werden die Busbars (Kontaktbahnen) 34 für die weitere Zellverschaltung durch Laserschweißen beider Kontaktpolaritäten (Emitter und Basis) mit Folienstreifen aus einer Metallfolie erzeugt. Die Folienstreifen können die jeweils andere Polarität überlappen. Eine dielektrische Schicht bzw. ein Schichtstapel isoliert die Folienstreifen von der komplementären Polarität.

Im einfachsten Fall werden Streifen aus Aluminiumfolie verwendet, die auf der den Kontakten 28 zugewandten Seite mit einer isolierenden Eloxierschicht versehen ist. Der Laserschweißprozess erfolgt durch die isolierende Schicht hindurch zu je einer Polarität.

Es kann natürlich auch eine andere dielektrische Schicht bzw. ein Schichtstapel auf den Folienstreifen oder auf der Rückseite des Wafers zur Isolierung verwendet werden.

## Patentansprüche

1. Verfahren zur Herstellung rückseitenkontaktierter Solarzellen aus kristallinem Silizium, mit den folgenden Schritten:
(a) Dotieren zur Erzeugung eines n-Typ- oder p-Typ-dotierten Bereiches (20, 22), vorzugsweise mittels Laserdotierung;
(b) Freilegung von Kontaktflächen (26) an der Rückseite der Solarzelle (10), vorzugsweise mittels Laserablation;
(c) Applizieren einer Metallschicht auf eine Rückseite der Solarzelle; und
(d) Strukturieren der Metallschicht mittels Laserablation zur Erzeugung von metallischen Kontakten (28), wobei der Pitch höchstens 800 Mikrometer beträgt,
**dadurch gekennzeichnet, dass**
in Schritt (c) eine Aluminiumschicht appliziert wird, dann eine gegen eine Eloxierung resistente Schicht appliziert wird, die im nachfolgenden Schritt (d) mittels Laser selektiv ablatiert wird und anschließend in den ablatierten Bereichen vollständig eloxiert wird.

2. Verfahren nach Anspruch 1, bei dem der dotierte Bereich (20, 22) durch Laserdotieren erzeugt wird.

3. Verfahren nach Anspruch 1, bei dem der Pitch (p) höchstens 500 Mikrometer, weiter bevorzugt höchstens 100 Mikrometer, besonders bevorzugt höchstens 60 Mikrometer beträgt.

4. Verfahren nach Anspruch 1 oder 2, bei dem der Pitch (p) mindestens 5 Mikrometer beträgt.

5. Verfahren nach einem der vorhergehenden Ansprüche, bei dem die metallischen Kontakte (28) durch Busbars (34) verschaltet werden, die aus Streifen aus Metallfolie bestehen, die unter Zwischenlage mindestens einer dielektrischen Schicht mittels Laserschweißen durch die dielektrische Schicht hindurch kontaktiert werden.

6. Verfahren nach Anspruch 5, bei dem Streifen aus eloxierter Aluminiumfolie zur Erzeugung der Busbars (34) verwendet werden.

7. Verfahren nach einem der vorhergehenden Ansprüche, bei dem zur Erzeugung eines p-Typ-Emitters (20) und/oder zur Erzeugung eines n-Typ Back Surface Fields (BSF) (22) auf der Rückseite der Solarzelle (10) ein Laserdotierschritt verwendet wird.

8. Verfahren nach einem der vorhergehenden Ansprüche, bei dem eine Precursor-Schicht, die einen Dotierstoff, insbesondere Bor, Aluminium oder Gallium enthält, auf der Rückseite der Solarzelle (10) abgeschieden wird und ein p-Typ-Emitter (20) durch lokale Bestrahlung mittels eines gepulsten Lasers erzeugt wird.

9. Verfahren nach einem der Ansprüche 1 bis 7, bei dem ein p-Typ-Emitter (20) lokal durch Ionenimplantation mit einem Dotierstoff, insbesondere Bor, Aluminium oder Gallium, erzeugt wird.

10. Rückseitenkontaktierte Solarzelle, hergestellt nach einem dem vorhergehenden Ansprüche, mit einem Wafer (16) mit einer Anti-Reflexionsschicht (12) auf der Vorderseite, mit einem Emitterbereich (20) und einem Basisbereich (Back Surface Field) (22) auf der Rückseite, und mit durch Laserablation hergestellten Kontakten (28) auf der Rückseite, wobei der Pitch (p) höchstens 800 Mikrometer beträgt.

11. Solarzelle nach Anspruch 10, bei welcher der Pitch (p) höchstens 500 Mikrometer, weiter bevorzugt höchstens 100 Mikrometer, besonders bevorzugt höchstens 60 Mikrometer beträgt, wobei vorzugsweise der Pitch (p) höchstens 5 Mikrometer beträgt.

12. Solarzelle nach Anspruch 10 oder 11, bei welcher die Kontakte (28) von Basisbereichen (22) und Emitterbereichen (18) durch Busbars (34) aus Metallfolienstreifen verschaltet sind, die durch Laserschweißpunkte (38) durch eine dielektrische Schicht hindurch elektrisch verbunden sind.

13. Solarzelle nach Anspruch 12, bei welcher die Metallfolienstreifen (34) aus eloxierter Aluminiumfolie bestehen.

## Claims

1. A method for producing back surface contact solar cells from crystalline silicon, having the following steps:
(a) Doping, preferably by means of laser doping, for producing an n-doped or p-doped region (20, 22);
(b) Exposing contact surfaces (26) on the back surface of the solar cell (10), preferably by means of laser ablation;
(c) Applying a metal layer to a back surface of the solar cell; and,
(d) Structuring the metal layer by means of laser ablation for producing metal contacts (28), wherein the pitch is at most 800 micrometers
**characterized in that**
in step (c) an aluminum layer is applied, then a layer which is resistant to anodization is applied, which in the subsequent step (d) is selectively ablated by means of laser and then is completely anodized in the ablated regions.

2. The method according to claim 1, in which method the doped region (20, 22) is produced using laser doping.

3. The method according to claim 1, in which method the pitch (p) is at most 500 micrometers, more preferably at most 100 micrometers, particularly preferably at most 60 micrometers.

4. The method according to claim 1 or 2, in which method the pitch (p) is at least 5 micrometers.

5. The method according to any of the foregoing claims, in which method the metal contacts (28) are connected using bus-bars (34) that comprise strips of metal foil that are contacted by means of laser welding through at least one interposing dielectric layer.

6. The method according to claim 5, in which method strips made of anodized aluminum foil are used to produce the bus-bars (34).

7. The method according to any of the foregoing claims, in which method a laser doping step is used for producing a p-type emitter (20) and/or for producing an n back surface field (BSF) (22) on the back surface of the solar cell (10).

8. The method according to any of the foregoing claims, in which method a precursor layer that contains a dopant, in particular boron, aluminum, or gallium, is deposited on the back surface of the solar cell (10) and a p-type emitter (20) is created using local irradiation by means of a pulsed laser.

9. The method according to any of claims 1 through 7, in which method a p-type emitter (20) is created locally using ion implantation with a dopant, in particular boron, aluminum, or gallium.

10. A back surface contact solar cell, produced according to any of the foregoing claims, having a wafer (16) with an anti-reflection layer (12) on the front surface, with an emitter region (20) and a base region (back surface field) (22) on the back surface, and having contacts (28) on the back surface that were produced by laser ablation, wherein the pitch (p) is at most 800 micrometers.

11. A solar cell according to claim 10, in which solar cell the pitch (p) is at most 500 micrometers, more preferably at most 100 micrometers, particularly preferably at most 60 micrometers, wherein the pitch (p) is preferably at most 5 micrometers.

12. The solar cell according to claim 10 or 11, in which solar cell the contacts (28) of base regions (22) and emitter regions (18) are connected using bus-bars (34) made of metal foil strips that are electrically connected using laser welding points (38) through a dielectric layer.

13. The solar cell according to claim 12, in which solar cell the metal foil strips (34) comprise anodized aluminum foil.

## Revendications

1. Procédé de fabrication de cellules solaires à contacts sur la face arrière composées de silicium cristallin, comprenant les étapes suivantes :
(a) le dopage pour la production d'une zone dopée (20, 22) de type n ou de type p, de préférence au moyen d'un dopage laser ;
(b) la mise à nu de surfaces de contact (26) sur la face arrière de la cellule solaire (10), de préférence au moyen d'une ablation par laser ;
(c) l'application d'une couche de métal sur une face arrière de la cellule solaire ; et
(d) la structuration de la couche de métal au moyen d'une ablation par laser pour la production de contacts métalliques (28), dans lequel le pas atteint au maximum 800 micromètres,
**caractérisé en ce que**
à l'étape (c), une couche d'aluminium est appliquée, puis une couche résistante à une anodisation est appliquée, qui fait l'objet d'une ablation sélective par laser à l'étape (d) suivante puis est entièrement anodiséee dans les zones ayant fait l'objet d'une ablation.

2. Procédé selon la revendication 1, pour lequel la zone dopée (20, 22) est produite par dopage laser.

3. Procédé selon la revendication 1, pour lequel le pas (p) atteint au maximum 500 micromètres, plus préférablement au maximum 100 micromètres, de manière particulièrement préférée au maximum 60 micromètres.

4. Procédé selon la revendication 1 ou 2, pour lequel le pas (p) atteint au moins 5 micromètres.

5. Procédé selon l'une quelconque des revendications précédentes, pour lequel les contacts (28) métalliques sont raccordés par des barres omnibus (34), qui sont constituées de bandes composées de feuille de métal, qui, avec interposition d'au moins une couche diélectrique, sont mises en contact à travers la couche diélectrique au moyen d'un soudage laser.

6. Procédé selon la revendication 5, pour lequel des bandes composées d'une feuille d'aluminium anodisée sont utilisées pour la production de la barre omnibus (34) .

7. Procédé selon l'une quelconque des revendications précédentes, pour lequel, pour la production d'un émetteur de type p (20) et/ou pour la production d'un champ de surface arrière (BSF) de type (22) sur la face arrière de la cellule solaire (10), une étape de dopage laser est utilisée.

8. Procédé selon l'une quelconque des revendications précédentes, pour lequel une couche de précurseur, qui contient un dopant, en particulier du bore, de l'aluminium ou du gallium, est déposée sur la face arrière de la cellule solaire (10) et un émetteur (20) de type p est produit par irradiation locale au moyen d'un laser pulsé.

9. Procédé selon l'une quelconque des revendications 1 à 7, pour lequel un émetteur (20) de type p est produit localement par implantation ionique avec un dopant, en particulier du bore, de l'aluminium ou du gallium.

10. Cellule solaire à contacts électriques sur la face arrière, fabriquée selon l'une quelconque des revendications précédentes, avec une tranche (16) avec une couche antireflet (12) sur la face avant, avec une zone d'émission (20) et une zone de base (champ de surface arrière) (22) sur la face arrière, et avec des contacts (28) fabriqués par ablation par laser sur la face arrière, dans lequel le pas (p) atteint au maximum 800 micromètres.

11. Cellule solaire selon la revendication 10, pour laquelle le pas (p) atteint au maximum 500 micromètres, plus préférablement au maximum 100 micromètres, de manière particulièrement préférée au maximum 60 micromètres, dans laquelle de préférence le pas (p) atteint au maximum 5 micromètres.

12. Cellule solaire selon la revendication 10 ou 11, pour laquelle les contacts (28) des zones de base (22) et zones d'émission (18) sont raccordés par des barres omnibus (34) composées de bandes de feuille métallique, qui sont reliées électriquement à travers une couche diélectrique par des points de soudage laser (38) .

13. Cellule solaire selon la revendication 12, pour laquelle les bandes en feuille de métal (34) sont constituées de feuille d'aluminium anodisée.
